# EUROPÄISCHE PATENTSCHRIFT

(11) **EP 1 760 796 B1**
(45) Veröffentlichungstag und Bekanntmachung des Hinweises auf die Patenterteilung: **03.12.2008**
(21) Anmeldenummer: 06117215.1
(22) Anmeldetag: 14.07.2006
(51) Int. Cl.: H01L 41/12, F02M 51/06

(54) **Vorrichtung mit einem Formgedächtniselement**
Device comprising a shape memory element
Dispositif comprenant un élément à mémoire de forme

(30) Priorität: 31.08.2005 DE 102005041210
(43) Veröffentlichungstag der Anmeldung: 07.03.2007
(73) Patentinhaber: ROBERT BOSCH GMBH, 70442 Stuttgart (DE)
(72) Erfinder: Hoang, Anh-Tuan, 71732, Tamm (DE); Maier, Martin, 71696, Moeglingen (DE); Hohl, Guenther, 70569, Stuttgart (DE)

(56) Entgegenhaltungen:
- DE-A1- 19 918 976
- JP-A- 8 316 541
- JP-A- 2001 280 215
- US-A- 3 045 491
- US-B1- 6 515 382
- TICKLE R ET AL: "Magnetic and magnetomechanical properties of Ni2MnGa" JOURNAL OF MAGNETISM AND MAGNETIC MATERIALS, ELSEVIER SCIENCE PUBLISHERS, AMSTERDAM, NL, Bd. 195, Nr. 3, Juni 1999 (1999-06), Seiten 627-638, XP004177994 ISSN: 0304-8853

## Beschreibung

### Stand der Technik

Die Erfindung geht aus von einer Vorrichtung mit einem Formgedächtniselement.
Es ist schon eine Vorrichtung mit einem Formgedächtniselement aus der JP-2001280215 A bekannt, mit einem Formgedächtniselement, das durch Anlegen eines regelbaren Magnetfeldes in Richtung der Magnetfeldlinien eine Kontraktion und in einer Richtung quer zu den Magnetfeldlinien eine Ausdehnung ausführt, wobei das Formgedächtniselement in einem Stellgehäuse angeordnet ist. Nachteilig ist, dass in dem Stellgehäuse kein Dehnungsspalt vorgesehen ist, in den hinein sich das Formgedächtniselement ausdehnen kann.

### Vorteile der Erfindung

Die erfindungsgemäße Vorrichtung hat demgegenüber den Vorteil, daß auf einfache Art und Weise die Lagerung des Formgedächtniselementes verbessert wird, indem das Formgedächtniselement an zumindest einer seiner Seitenflächen eine Lagerung aufweist, die ausschließlich im Bereich einer neutralen Ebene liegt, die durch Seitenflächen des Formgedächtniselements begrenzt ist und in der das Formgedächtniselement durch Anlegen des Magnetfeldes keine Querausdehnung erfährt.

Durch die in den Unteransprüchen aufgeführten Maßnahmen sind vorteilhafte Weiterbildungen und Verbesserungen der im Hauptanspruch angegebenen Vorrichtung möglich.

Besonders vorteilhaft ist, wenn die Lagerung eine formschlüssige und/oder stoffschlüssige Verbindung zwischen dem Formgedächtniselement und zumindest einer Wandung des Stellgehäuses herstellt, da die Lagerung auf diese Weise sehr einfach und kostengünstig ausführbar ist.

Weiterhin vorteilhaft ist, dass die formschlüssige und/oder stoffschlüssige Verbindung linienförmig verläuft, da die Lagerung auf diese Weise ausschließlich im Bereich der neutralen Ebene verläuft.

Sehr vorteilhaft ist es, wenn das Formgedächtniselement zumindest eine Nut und die Wandung des Stellgehäuses zumindest eine Führung aufweist, die formschlüssig mit der zumindest einen Nut zusammenwirkt, oder umgekehrt, da auf diese Weise eine einfache formschlüssige Verbindung erreicht wird.

Auch vorteilhaft ist, wenn eine Stirnfläche des Formgedächtniselementes mittels Kleben mit der Wandung des Stellgehäuses verbunden ist, da auf diese Weise eine sehr einfache und kostengünstige Lagerung erzielbar ist.

Desweiteren vorteilhaft ist, wenn das Formgedächtniselement an zwei gegenüberliegenden Mantelflächen jeweils an einem Lagerelement des Stellgehäuses formschlüssig anliegt, da auf diese Weise eine gute Führung und Lagerung des Formgedächtniselementes erreichbar ist.

Darüber hinaus vorteilhaft ist, wenn zwischen dem Stellgehäuse und dem Formgedächtniselement in Richtung der Ausdehnung jeweils ein Dehnungsspalt vorgesehen ist, da sich das Formgedächtniselement auf diese Weise in den Dehnungsspalt hinein ausdehnen kann, ohne dabei verspannt zu werden.

### Zeichnung

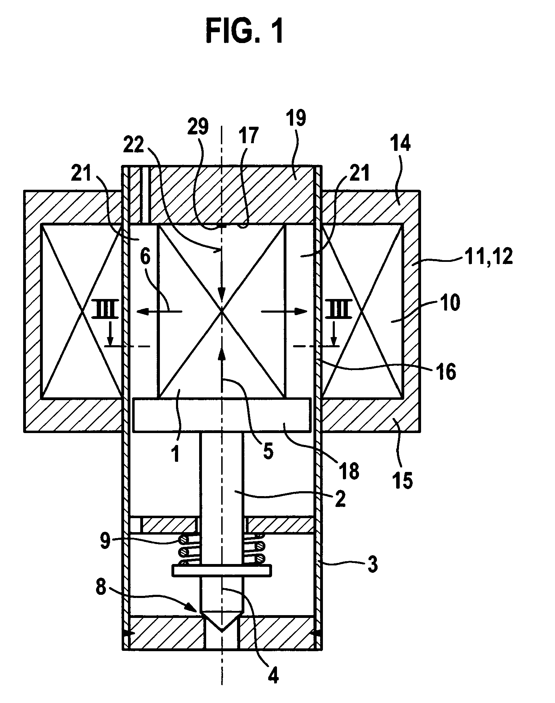

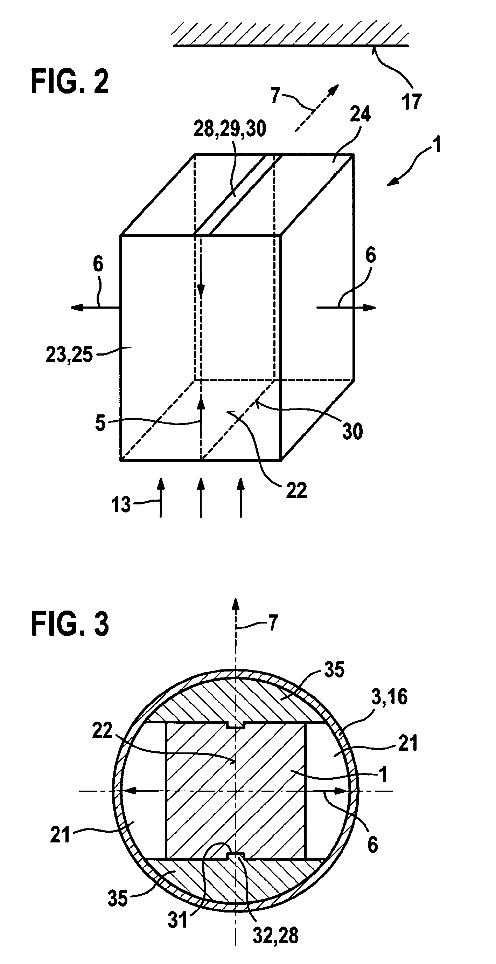

Ausführungsbeispiele der Erfmdung sind in der Zeichnung vereinfacht dargestellt und in der nachfolgenden Beschreibung näher erläutert. Es zeigen Fig.1 ein Brennstoffeinspritzventil mit einem Formgedächtniselement, Fig.2 ein Formgedächtniselement gemäß einem ersten Ausführungsbeispiel und Fig.3 im Schnitt eine Ansicht des Brennstoffeinspritzventils entlang der Linie III-III in Fig.1 gemäß einem zweiten Ausführungsbeispiel.

### Beschreibung der Ausführungsbeispiele

Fig.1 zeigt eine vereinfachte Ansicht eines Brennstoffeinspritzventils mit einem Formgedächtnisaktor.

Die erfindungsgemäße Vorrichtung dient dazu, mittels eines Hubs eines Formgedächtniselementes ein Stellglied zu betätigen. Die Vorrichtung ist z.B. ein beliebiges Ventil, beispielsweise ein Brennstoffeinspritzventil, und das Stellglied eine Ventilnadel oder ein Ventilstift.

Die erfindungsgemäße Vorrichtung weist zumindest ein Formgedächtniselement 1 auf, das als Aktor ein zugeordnetes Stellglied 2 betätigt. Das Formgedächtniselement 1 und das Stellglied 2 sind in einem Stellgehäuse 3 angeordnet, das beispielsweise zylinderförmig ausgeführt ist. Das Stellglied 2 ist in Richtung einer Stellachse 4 axial beweglich, wirkt beispielsweise mit einem am Stellgehäuse 3 ausgebildten Ventilsitz 8 zusammen und wird mittels einer Rückstellfeder 9 in Richtung des Ventilsitzes 8 gedrückt. Das zumindest eine Formgedächtniselement 1 besteht beispielsweise aus einer magnetischen Formgedächtnislegierung.

Das beispielsweise quaderförmige Formgedächtniselement 1 führt bei Anlegen eines Magnetfeldes einen das Stellglied 2 betätigenden Stellhub aus, indem es sich in Richtung der Magnetfeldlinien 13 (Fig.2) des Magnetfeldes zusammenzieht. Der Stellhub verläuft in Richtung 5 der Stellachse 4. Zusätzlich zu der Kontraktion dehnt sich das Formgedächtniselement 1 in einer Richtung 6 quer zu den Magnetfeldlinien aus. Eine dritte Richtung 7 (Fig.2) des Formgedächtniselementes 1 bleibt beim Anlegen des Magnetfeldes neutral. In der dritten Richtung 7 erfolgt also keine Bewegung, weder eine Kontraktion noch eine Ausdehnung. Die Richtung 5 des Stellhubes, die Richtung 6 der Ausdehnung und die neutrale Richtung 7 stehen beispielsweise jeweils senkrecht zueinander.

Das Magnetfeld wird beispielsweise mit einer elektrischen Spule 10 erzeugt, die das Stellgehäuse 3 und das in dem Stellgehäuse vorgesehene Formgedächtniselement 1 ringförmig umgibt. Die elektrische Spule 10 ist beispielsweise in einem Magnetgehäuse 11 angeordnet, das am Umfang des Stellgehäuses 3 im axialen Bereich des Formgedächtniselementes 1 vorgesehen ist. Das Magnetgehäuse 11 weist beispielsweise einen Zylinderabschnitt 12 auf, an dem stimseitig jeweils eine bezüglich der Stellachse 4 in radialer Richtung verlaufende Stimwandung 14,15 angeordnet ist. Die Stimwandungen 14,15 sind in axialer Richtung bezüglich der Stellachse 4 zueinander beabstandet und reichen in radialer Richtung schulterförmig bis an das Stellgehäuse 3. In radialer Richtung gesehen zwischen der elektrischen Spule 10 und dem Formgedächtniselement 1 verläuft in axialer Richtung gesehen zwischen den beiden Stimwandungen 14,15 ein Gehäuseabschnitt 16 des Stellgehäuses 3, der das Formgedächtniselement 1 und die elektrische Spule 10 voneinander trennt. Der Gehäuseabschnitt 16 ist so ausgeführt, dass kein relevanter Magnetfluss über ihn geleitet wird. Dies kann beispielsweise durch dünnwandige Gestaltung oder magnetisch nichtleitende Materialien erreicht werden.

Das Formgedächtniselement 1 ist in axialer Richtung gesehen zwischen einer Wandung 17 des Stellgehäuses 3 und einer Schulter 18 des Stellglieds 2 angeordnet. Die Wandung 17 ist beispielsweise an einem stirnseitigen Deckel 19 des Stellgehäuses 3 ausgebildet. Die Schulter 18 des Stellglieds 2 verläuft in radialer Richtung bis nahe an das Stellgehäuse 3 und ist hinsichtlich der axialen Lage im Bereich der unteren Stirnwandung 15 des Magnetgehäuses 11 vorgesehen. Die Schulter 18 wird an der Wandung des Stellgehäuses 3 geführt. Die von der elektrischen Spule 10 erzeugbaren Magnetfeldlinien verlaufen auf diese Weise kreisförmig geschlossen zumindest über den Zylinderabschnitt 12, die untere Stimwandung 15, über die Schulter 18 des Stellglieds 2, in axialer Richtung durch das Formgedächtniselement 1, die Wandung 17 des Stellgehäuses 3 und über die obere Stimwandung 14 des Magnetgehäuses 11.

Durch die Kontraktion des Formgedächtniselementes 1 in Richtung der Stellachse 4 wird das Stellglied 2 von dem Ventilsitz 8 abgehoben, so dass die Vorrichtung geöffnet wird.

Auf diese Weise wird beispielsweise ein nach innen, zum Formgedächtniselement 1 hin öffnendes Ventil erreicht.

Das Formgedächtniselement 1 ist in dem Stellgehäuse 3 derart axial und/oder radial gelagert, dass sowohl die Kontraktion als auch die Ausdehnung ausführbar sind. Dazu ist in Richtung der Ausdehnung 6 ein Dehnungsspalt 21 zwischen dem Gehäuseabschnitt 16 des Stellgehäuses 3 und dem Formgedächtniselement 1 erforderlich.

Fig.2 zeigt ein quaderförmiges Formgedächtniselement gemäß einem ersten Ausführungsbeispiel.

Bei dem Formgedächtniselement nach Fig.2 sind die gegenüber der Vorrichtung nach Fig.1 gleichbleibenden oder gleichwirkenden Teile durch die gleichen Bezugszeichen gekennzeichnet.

Das Formgedächtniselement 1 weist eine neutrale Ebene 22 auf, die durch die erste Richtung 5 und die dritte Richtung 7 aufgespannt wird. Beidseitig der neutralen Ebene 22 dehnt sich das Formgedächtniselement 1 in entgegengesetzter Richtung 6 aus, so dass in der neutralen Ebene keine Ausdehnung in der zweiten Richtung 6 erfolgt. Innerhalb der neutralen Ebene 22 erfolgt nur eine Kontraktion in der ersten Richtung 5. Die neutrale Ebene 22 verläuft innerhalb des Formgedächtniselementes 1 und wird durch beispielsweise vier Seitenflächen 23 des Formgedächtniselementes 1 begrenzt, zwei Stirnflächen 24 und zwei Mantelflächen 25.

Erfindungsgemäß weist das Formgedächtniselement 1 an zumindest einer seiner Seitenflächen 23 eine Lagerung 28 auf, die ausschließlich im Bereich der neutralen Ebene 22 liegt. Da in der neutralen Ebene 22 keine Ausdehnung in der zweiten Richtung 6 erfolgt, kann das Formgedächtniselement 1 in diesem Bereich einfach gelagert werden.

Gemäß einem ersten Ausführungsbeispiel ist die Lagerung 28 derart gebildet, dass das Formgedächtniselement 1 mit einer Stirnfläche 24 an der Wandung 17 des Stellgehäuses 3 stoffschlüssig befestigt ist, beispielsweise mittels Kleben, wobei diese Verbindung 29 linienförmig bzw. nahtförmig ausschließlich im Bereich der neutralen Ebene 22 vorgesehen ist. Die beispielsweise stoffschlüssige Verbindung 29 ist an oder nahe einem Rand 30 der neutralen Ebene 22 angeordnet.

Fig.3 zeigt im Schnitt eine Ansicht der Vorrichtung entlang der Linie III-III in Fig.1 gemäß einem zweiten Ausführungsbeispiel.

Bei der Vorrichtung nach Fig.3 sind die gegenüber der Vorrichtung nach Fig.1 und Fig.2 gleichbleibenden oder gleichwirkenden Teile durch die gleichen Bezugszeichen gekennzeichnet.

Die Vorrichtung gemäß dem zweiten Ausführungsbeispiel unterscheidet sich gegenüber der Vorrichtung gemäß dem ersten Ausführungsbeispiel darin, dass die Lagerung 28 nicht stoffschlüssig, sondern formschlüssig ausgebildet ist, indem das Formgedächtniselement 1 zumindest an einer Mantelfläche 25 eine Nut 31 aufweist, in die eine mit dem Stellgehäuse 3 fest verbundene Führung 32 formschlüssig hineinragt. Beispielsweise weist das Formgedächtniselement 1 an zwei gegenüberliegenden Mantelflächen 25 eine Nut 31 auf. In dem Gehäuseabschnitt 16 sind zwei kreisabschnittförmige Lagerelemente 35 angeordnet, die jeweils mit ihrer ebenen Fläche an einer Mantelfläche 25 des Formgedächtniselementes 1 anliegen und an ihrer gewölbten Fläche mit dem Stellgehäuse 3 fest, beispielsweise einstückig, verbunden sind. An der ebenen Fläche der Lagerelemente 35 ist jeweils im Bereich der neutralen Ebene 22 die stegförmige, hervorstehende Führung 32 ausgebildet. In der zweiten Richtung 6 gesehen ist zwischen dem Stellgehäuse 3 und dem Formgedächtniselement 1 der Dehnungsspalt 21 vorgesehen.

Es kann auch umgekehrt vorgesehen sein, dass die Führung 32 an dem Formgedächtniselement 1 und die Nut 31 an dem Stellgehäuse 3 ausgebildet ist.

Auch eine Kombination des ersten und zweiten Ausführungsbeispiels ist möglich, bei der das Formgedächtniselement 1 an der Stirnfläche 24 stoffschlüssig und an zumindest einer Mantelfläche 25 formschlüssig gelagert ist.

## Patentansprüche

1. Vorrichtung mit zumindest einem Formgedächtniselement, das durch Anlegen eines regelbaren Magnetfeldes in Richtung (5) der Magnetfeldlinien eine Kontraktion, in einer Richtung (6) quer zu den Magnetfeldlinien eine Ausdehnung ausführt und in einer bezüglich der Querausdehnung (6) neutralen Ebene des Formgedächtniselementes (1), die durch Seitenflächen des Formgedächtniselemente (1) begrenzt ist, keine Querausdehnung erfährt, wobei das Formgedächtniselement (1) in einem Stellgehäuse (3) angeordnet ist und das Formgedächtniselement (1) an zumindest einer seiner Seitenflächen (23) eine Lagerung (28) aufweist, die ausschließlich im Bereich der neutralen Ebene (22) liegt.

2. Vorrichtung nach Anspruch 1, **dadurch gekennzeichnet, dass** die Lagerung (28) eine formschlüssige und/oder stoffschlüssige Verbindung (29) zwischen dem Formgedächtniselement (1) und zumindest einer Wandung (17) des Stellgehäuses (3) herstellt.

3. Vorrichtung nach Anspruch 2, **dadurch gekennzeichnet, dass** die formschlüssige und/oder stoffschlüssige Verbindung (29) linienförmig verläuft.

4. Vorrichtung nach Anspruch 2, **dadurch gekennzeichnet, dass** das Formgedächtniselement (1) zumindest eine Nut (31) und die Wandung (17) des Stellgehäuses (3) zumindest eine Führung (32) aufweist, die formschlüssig mit der zumindest einen Nut (31) zusammenwirkt, oder umgekehrt.

5. Vorrichtung nach Anspruch 2, **dadurch gekennzeichnet, dass** eine Stirnfläche (24) des Formgedächtniselementes (1) mittels Kleben mit der Wandung (17) des Stellgehäuses (3) verbunden ist.

6. Vorrichtung nach Anspruch 1, **dadurch gekennzeichnet, dass** das Formgedächtniselement (1) quaderförmig ausgeführt ist.

7. Vorrichtung nach Anspruch 6, **dadurch gekennzeichnet, dass** das Formgedächtniselement (1) an zwei gegenüberliegenden Mantelflächen (25) jeweils an einem Lagerelement (35) des Stellgehäuses (3) anliegt.

8. Vorrichtung nach Anspruch 1**, dadurch gekennzeichnet, dass** zwischen dem Stellgehäuse (3) und dem Formgedächtniselement (1) in Richtung der Ausdehnung (6) jeweils ein Dehnungsspalt (21) vorgesehen ist.

9. Verwendung einer Vorrichtung nach einem der Ansprüche 1 bis 8 in einem Brennstoffeinspritzventil.

## Claims

1. Device having at least one form memory element which, by a regulatable magnetic field being applied, performs a contraction in the direction (5) of the magnetic flux lines, performs an expansion in a direction (6) transverse to the magnetic flux lines and experiences no transverse expansion in a plane of the form memory element (1) which is neutral with respect to the transverse expansion (6) and which is delimited by side faces of the form memory element (1), the form memory element (1) being arranged in an actuating housing (3), and the form memory element (1) having, on at least one of its side faces (23), a mounting (28) which lies solely in the region of the neutral plane (22).

2. Device according to Claim 1, **characterized in that** the mounting (28) makes a positive and/or materially integral connection (29) between the form memory element (1) and at least one wall (17) of the actuating housing (3).

3. Device according to Claim 2, **characterized in that** the positive and/or materially integral connection (29) runs linearly.

4. Device according to Claim 2, **characterized in that** the form memory element (1) has at least one groove (31) and the wall (17) of the actuating housing (3) has at least one guide (32) which co-operates positively with the at least one groove (31), or vice versa.

5. Device according to Claim 2, **characterized in that** one end face (24) of the form memory element (1) is connected to the wall (17) of the actuating housing (3) by means of adhesive bonding.

6. Device according to Claim 1, **characterized in that** the form memory element (1) is of parallelepipedal design.

7. Device according to Claim 6, **characterized in that** the form memory element (1) bears against a bearing element (35) of the actuating housing (3) on each of two surface areas (25) lying opposite one another.

8. Device according to Claim 1, **characterized in that** an expansion gap (21) is provided in each case in the direction of expansion (6) between the actuating housing (3) and the form memory element (1).

9. Use of a device according to one of Claims 1 to 8 in a fuel injection valve.

## Revendications

1. Dispositif comportant au moins un élément à mémoire de forme qui, par application d'un champ magnétique réglable effectue une contraction, dans la direction (5) des lignes de champ magnétique, et une extension, dans la direction (6) transversale à celle des lignes de champ magnétique, et dans un plan neutre de l'élément à mémoire de forme (1), par rapport à l'extension transversale (6), ce plan étant délimité par les surfaces latérales de l'élément à mémoire de forme (1), il ne subit aucune extension transversale,
l'élément à mémoire de forme (1) étant placé dans un boîtier d'actionneur (3), et
l'élément à mémoire de forme (1) comporte sur au moins l'une de ses surfaces latérales (23), un palier (28) qui se situe exclusivement dans la zone du plan neutre (22).

2. Dispositif selon la revendication 1,
**caractérisé en ce que**
le palier (28) réalise une liaison (29) par la forme et/ou par la matière entre l'élément à mémoire de forme (1) et au moins une paroi (17) du boîtier d'actionneur (3).

3. Dispositif selon la revendication 2,
**caractérisé en ce que**
la liaison (29) par la forme et/ou par la matière est linéaire.

4. Dispositif selon la revendication 2,
**caractérisé en ce que**
l'élément à mémoire de forme (1) comporte au moins une rainure (31) et la paroi (17) du boîtier d'actionneur (3) comporte au moins un moyen de guidage (32) qui coopère par une liaison par la forme avec au moins la rainure (31) et réciproquement.

5. Dispositif selon la revendication 2,
**caractérisé en ce qu'**
une surface frontale (24) de l'élément à mémoire de forme (1) est reliée par collage à la paroi (17) du boîtier d'actionneur (3).

6. Dispositif selon la revendication 1,
**caractérisé en ce que**
l'élément à mémoire de forme (1) est en forme de parallélépipède.

7. Dispositif selon la revendication 6,
**caractérisé en ce que**
l'élément à mémoire de forme (1) est appliqué contre deux surfaces enveloppes opposées (25), chaque fois contre un élément de palier (35) du boîtier d'actionneur (3).

8. Dispositif selon la revendication 1,
**caractérisé par**
un intervalle de dilatation (21) prévu entre le boîtier d'actionneur (3) et l'élément à mémoire de forme (1) dans la direction de l'extension (6).

9. Application d'un dispositif selon les revendications 1 à 8, à un injecteur de carburant.
